# EUROPEAN PATENT APPLICATION

(11) **EP 4 818 724 A1**
(43) Date of publication of application: **07.10.2026**
(21) Application number: 26165796.9
(22) Date of filing: 18.03.2026
(51) Int. Cl.: G01R 31/392

(54) **SYSTEMS AND METHODS FOR AUTOMATICALLY TESTING A BATTERY AND ESTIMATING A SAFETY STATE USING A TESTING SYSTEM**

(30) Priority: 04.04.2025 US 202519170588
(71) Applicant: TOYOTA MOTOR ENGINEERING & MANUFACTURING NORTH AMERICA, INC., Plano, TX 75024 (US)
(72) Inventor: ISHIGAKI, Masanori, Plano, 75024 (US)
(74) Representative: J A Kemp LLP

(57) **Abstract**

Systems, methods, and other embodiments described herein relate to testing a used battery by measuring signals until satisfying a connection parameter for estimating a safety state. In one embodiment, a method includes measuring s-parameters for ports of a used battery at elevated frequencies using a testing device. The method also includes, upon satisfying a connection parameter associated with the ports, removing interference sources by computing first derivatives of real-parts from impedance using the s-parameters. The method also includes estimating a safety state for the used battery from changes of the first derivatives over a frequency band.

## Description

### TECHNICAL FIELD

The subject matter described herein relates, in general, to testing a used battery, and, more particularly, to testing the used battery by measuring signals until satisfying a connection parameter for estimating a safety state using a testing system.

### BACKGROUND

Drawing power from a traction battery by an electric vehicle is a clean and sustainable alternative to burning fossil fuels, thereby reducing greenhouse emissions. EVs can also lower fuel and maintenance costs that improve economic value for consumers. However, traction batteries have a limited lifespan and environmental impact that is negative. For instance, vendors disposing of a traction battery harm the environment from metallic waste. In the case of lithium-ion batteries, disposal can cause toxic chemicals like cobalt, nickel, and manganese leaking into the soil and water. Traction batteries can also cause fires in landfills and recycling facilities that increase air pollution and lead to bodily injury for works. As such, systems implementing traction batteries in an EV encounter harmful environmental consequences at the end-of-life (EoL).

Systems reducing environmental impact at EOL include repurposing and remanufacturing a used battery. A repurpose application can involve installing the used battery from a vehicle as a backup source for a house. However, chemical breakdown and internal degradation associated with the used battery can limit reuse applications. For example, a lithium-ion battery encounters plating during charging when lithium ions deposit as metallic lithium on an anode. This degrades battery performance by reducing the available lithium for energy storage, increases internal resistance, and causes safety hazards from short circuits. Furthermore, systems testing the used battery for detecting lithium plating encounter difficulties from measurement tasks. Testing equipment can demand specialized probes and precise readings from the used battery. Such requirements can raise costs for testing equipment and hinder reuse applications. Therefore, testing and reusing a used battery from an EV has roadblocks associated with measurements and chemical defects that increase costs and complexity, thereby impacting repurposing applications.

### SUMMARY

In one embodiment, example systems and methods relate to testing a used battery by measuring signals until satisfying a connection parameter for estimating a safety state. In various implementations, a system measures a used battery using cables (e.g., coaxial cables) connected to a testing device in parallel with the used battery. For example, a test setup includes four contact points connected to a total +/- terminals of the used battery (e.g., a battery module). However, these systems encounter measurement challenges for detecting battery degradation and wear without disassembly. In particular, plating detection can demand measurement uniformity of input ports for precise impedance values that impact plating-related computations. Thus, systems testing a used battery for reuse and repurposing applications face challenges associated with setup configurations that reduce measurement confidence and reliability.

Therefore, in one embodiment, a testing system has testing fixtures and protocols that are specialized for automatically diagnosing a safety state at a module level rather than a cell level. In one approach measurement, the testing system externally measures s-parameters that are unitless representing reflectivity and losses during testing. In particular, the s-parameters can represent reflections and losses between probes and ports (e.g., output terminals, input terminals, etc.) of the used battery that allow the testing system to acquire fundamental information about impedance. Furthermore, the system removes certain interference sources to measure internal resistance at the module level from the impedance reliably using the s-parameters. This allows the testing system to estimate and diagnose the safety state for second life and reuse applications with less complexity while avoiding invasive testing. In this way, the testing system reliably and safely tests, measures, and detects degradation within a used battery non-invasively and identifies reuse applications for the used battery that reduce environmental waste.

In one embodiment, a testing system that tests a used battery by measuring signals until satisfying a connection parameter for estimating a safety state is disclosed. The testing system includes a memory including instructions that, when executed by a processor, cause the processor to measure s-parameters for ports of a used battery at elevated frequencies using a testing device. The instructions also include, upon satisfaction of a connection parameter associated with the ports, to remove interference sources by computing first derivatives of real-parts from impedance using the s-parameters. The instructions also include to estimate a safety state for the used battery from changes of the first derivatives over a frequency band.

In one embodiment, a non-transitory computer-readable medium for testing a used battery by measuring signals until satisfying a connection parameter for estimating a safety state and including instructions that when executed by a processor cause the processor to perform one or more functions is disclosed. The instructions include instructions to measure s-parameters for ports of a used battery at elevated frequencies using a testing device. The instructions also include instructions, upon satisfaction of a connection parameter associated with the ports, to remove interference sources by computing first derivatives of real-parts from impedance using the s-parameters. The instructions also include instructions to estimate a safety state for the used battery from changes of the first derivatives over a frequency band.

In one embodiment, a method for testing a used battery by measuring signals until satisfying a connection parameter for estimating a safety state is disclosed. In one embodiment, the method includes measuring s-parameters for ports of a used battery at elevated frequencies using a testing device. The method also includes, upon satisfying a connection parameter associated with the ports, removing interference sources by computing first derivatives of real-parts from impedance using the s-parameters. The method also includes estimating a safety state for the used battery from changes of the first derivatives over a frequency band.

### BRIEF DESCRIPTION OF THE DRAWINGS

The accompanying drawings, which are incorporated in and constitute a part of the specification, illustrate various systems, methods, and other embodiments of the disclosure. It will be appreciated that the illustrated element boundaries (e.g., boxes, groups of boxes, or other shapes) in the figures represent one embodiment of the boundaries. In some embodiments, one element may be designed as multiple elements or multiple elements may be designed as one element. In some embodiments, an element shown as an internal component of another element may be implemented as an external component and vice versa. Furthermore, elements may not be drawn to scale.
FIG. 1 illustrates one embodiment of a testing system that verifies a connection parameter for testing a used battery and estimates a safety state of a used battery associated with reuse and recycle applications.
FIG. 2 illustrates one embodiment of a testing fixture used by the testing system that verifies connections for electrical measurements and determines battery reuse opportunities.
FIG. 3 illustrates an example of the used battery having a module and a cell that the testing system analyzes.
FIGS. 4A and 4B illustrate embodiments of verifying port connections of the used battery through analyzing s-parameters and differential values.
FIG. 5 illustrates one embodiment of a method that is associated with measuring s-parameters for ports of the used battery and satisfying a connection parameter for estimating a safety state.

### DETAILED DESCRIPTION

Systems, methods, and other embodiments associated with testing a used battery by measuring signals until satisfying a connection parameter for estimating a safety state are disclosed herein. In various implementations, testing a battery demands contact quality between cables and ports (e.g., output terminals, input terminals, etc.). For example, terminals from two coaxial cables demand equal contact with the battery and contact verification. Otherwise, a testing device outputs erroneous measurements that reduce the accuracy of critical degradation and internal states. For instance, detecting metallic plating within cells without invasive probing and disassembly requires precise impedance derived from the voltage and current measurements. In other words, systems can encounter difficulties detecting plating and other degradation for a battery having closely integrated hardware and battery cells. Another approach involves systems utilizing high frequency-electrochemical impedance spectroscopy (HF-EIS) for measuring cell-level safety states and battery interference (e.g., contact interference, metal plating, etc.) from metal materials (e.g., lithium-ion). However, such measurements are costly and complex at diagnosing the safety state at the cell level associated with a battery. Therefore, systems testing a battery for physical degradation and plating using probes and cables encounter difficulties from contact quality, complex equipment, and invasive disassembly, thereby reducing opportunities for reuse applications, increasing costs, and increasing waste.

Therefore, in one embodiment, a testing system measures s-parameters that analyze capacity and output current from a used battery automatically, derives impedance from the s-parameters, and estimates a safety state for improving reuse applications. In one approach, the testing system includes a protocol that evaluates the measurement values of s-parameters to assess contact uniformity between probes and ports (e.g., output terminals, input terminals, etc.) of the used battery. For instance, the testing system factors reflection coefficients associated with the s-parameters from respective ports. This allows the testing system to independently analyze contact impedance of a port through a capacitive-resistance parallel circuit from the s-parameters and reflection coefficients, thereby accurately identifying contact quality for testing.

In various implementations, the testing system computes differential values between s-parameters in an elevated frequency range (e.g., above 1 MHz). By automatically adjusting the port pressure to fall within a tolerance range, the testing system can stabilize the connection between the used battery and the measuring instrument that facilitates reproducible testing evaluations. For instance, an actuator changes the position of a probe with a battery terminal in a three-dimensional (3D) space to reduce resistance and reflection coefficients until the differential value is minimal. The testing system can use satisfactory contact to diagnose a safety state from impedance computations. For example, the testing system removes interference sources by computing first derivatives of real-parts from impedance using the s-parameters. This allows detecting metal plating within a cell at a module level (e.g., 12 cells). In this way, the testing system through stabilizing connections with the used battery saves costs by avoiding complex testing equipment (e.g., spectroscopy) involving safety detection.

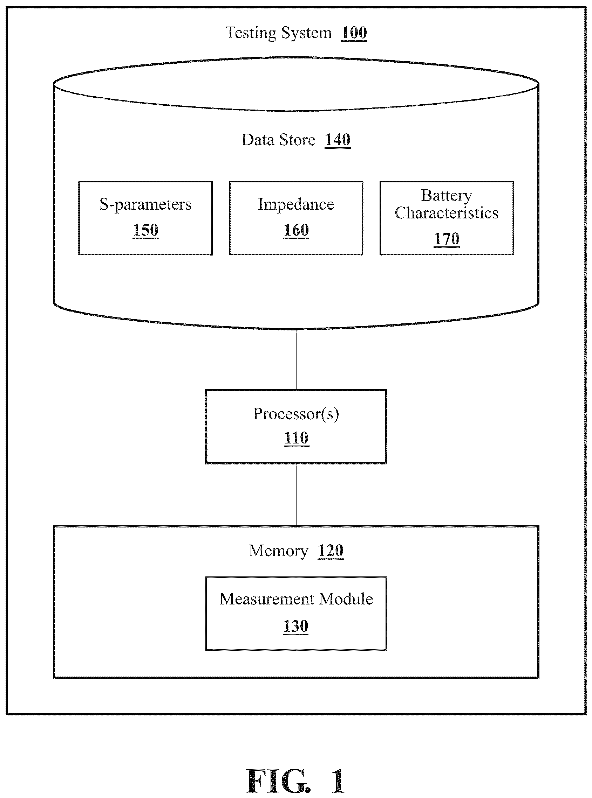

In certain implementations, the systems illustrated in FIGS. 1-5 also include various elements. It will be understood that in various embodiments, the systems may have less than the elements shown in FIGS. 1-5. The systems can have any combination of the various elements shown in FIGS. 1-5. Furthermore, the systems can have additional elements to those shown in FIGS. 1-5. In some arrangements, the systems may be implemented without one or more of the elements shown in FIGS. 1-5. While the various elements are shown as being located within the systems in FIGS. 1-5, it will be understood that one or more of these elements can be located external to the systems. Furthermore, the elements shown may be physically separated by large distances. Additionally, it will be appreciated that for simplicity and clarity of illustration, where appropriate, reference numerals have been repeated among the different figures to indicate corresponding or analogous elements. In addition, the discussion outlines numerous specific details to provide a thorough understanding of the embodiments described herein. Those of skill in the art, however, will understand that the embodiments described herein may be practiced using various combinations of these elements.

With reference to FIG. 1, one embodiment of a testing system 100 of FIG. 1 is further illustrated. Systems monitoring, detecting, etc., internal growth of Li-metal deposition is vital for evaluating a safety state, state of safety (SOS), etc., of lithium-ion batteries. The internal growth impacts thermal runaway temperature of lithium-ion batteries, thereby increasing reuse applications that are safe upon mitigation. Such testing demands sound and repeatable contact between testing probes and ports for reliable measurements. Here, the testing system 100 can measure s-parameters for ports of a used battery from a vehicle and adjusts contacts for measuring impedance. Furthermore, the testing system 100 can identify a temperature and a SOC by testing equipment to optimally measure impedance associated with the s-parameters associated with internal state detections. As such, a measurement module 130 of testing equipment measures the impedance within a certain frequency band that exhibits and enhances interference sources.

Moreover, the testing system 100 can remove the interference sources by computing first derivatives of real-parts from the impedance and factoring the temperature and the SOC. Furthermore, the testing system 100 estimates a safety state for the used battery from changes of the first derivatives within a frequency band. In one approach, the safety state indicates a degradation (e.g., a chemical degradation, a physical degradation, etc.) for one or more cells within a module associated with the used battery.

In one embodiment, the testing system 100 includes a memory 120 that stores the measurement module 130. The memory 120 is a random-access memory (RAM), a read-only memory (ROM), a hard-disk drive, a flash memory, or other suitable memory for storing the measurement module 130. The measurement module 130 is, for example, computer-readable instructions that when executed by the processor(s) 110 cause the processor(s) 110 to perform the various functions disclosed herein.

In FIG. 1, the measurement module 130 generally includes instructions that function to control the processor(s) 110 to receive data inputs from one or more sensors of the testing equipment. For instance, the testing system 100 identifies the s-parameters and measures impedance using hardware that applies a minimal alternating current (AC) signal into a module, cell, etc., and measures the response. Such testing equipment can precisely output detailed information about the internal resistance and reactance of a battery, such as a high-voltage battery used by an EV.

Moreover, in one embodiment, the testing system 100 includes a data store 140. In one embodiment, the data store 140 is a database. The database is, in one embodiment, an electronic data structure stored in the memory 120 or another data store and that is configured with routines that can be executed by the processor(s) 110 for analyzing stored data, providing stored data, organizing stored data, and so on. Thus, in one embodiment, the data store 140 stores data used by the measurement module 130 in executing various functions. In one embodiment, the data store 140 includes s-parameters 150, impedance 160, and battery characteristics 170. As explained below, the s-parameters 150 can be a unitless value about electrical characteristics and responses associated with a used battery. The impedance 160 can include an opposition measurement to electrical flow expressed using complex-valued generalization and Ohm (Ω) units. As such, impedance is similar to resistance in direct current (DC) systems. In AC systems, impedance incorporates reactance due to frequency-dependent contributions from capacitance and inductance. Impedance in an AC system is still measured in Ω units by the equation Z = *V*/*I* having *V* and *I* that are frequency-dependent. Regarding the battery characteristics 170, this information can include the safety state that indicates plating within a cell, a cell array, a module, etc., internal to the used battery.

In one approach, the testing system 100 and the measurement module 130 include instructions that cause the processor 110 to measure the s-parameters 150 for ports of a used battery at elevated frequencies using a testing device. The testing system 100 removes interference sources by computing first derivatives of real-parts from the impedance 160 using the s-parameters 150 upon satisfaction of a connection parameter associated with the ports. As further explained below, the testing system 100 estimates a safety state for the used battery from changes of the first derivatives over a frequency band.

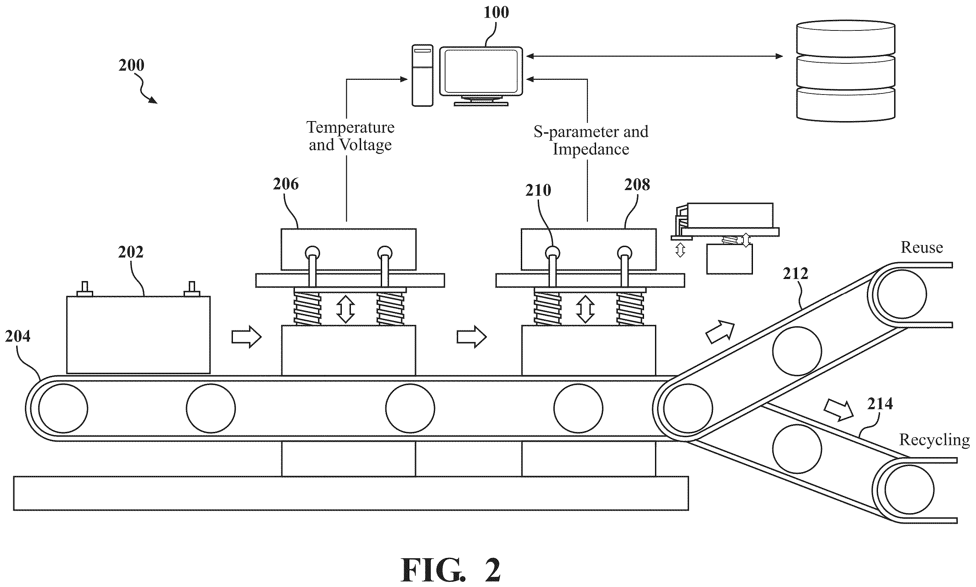

FIG. 2 illustrates one embodiment of a testing fixture 200 used by the testing system 100. The testing fixture 200 can verify and adjust connections for electrical measurements and predict battery reuse opportunities. In one approach, the testing system 100 uses a testing device that detects degradation (e.g., internal plating) of a used battery 202 through computing first derivatives of real-parts from the impedance 160 using the s-parameters 150. Upon satisfaction of a connection parameter associated with the ports using the s-parameters 150, the testing system 100 may estimate a safety state for the used battery 202 from changes of the first derivatives over a frequency band. Here, the used battery 202 can be one of a lithium-ion, solid state, magnesium, etc., battery. A conveyor device 204 transports the used battery 202 for temperature and voltage measurements by a first probe 206 at an initial stage. In one approach, the testing system 100 signals an actuator 210 to change position of the first probe 206 (e.g., coaxial cables, electrical clips, clamps, etc.) automatically for improving measurement fidelity. This can include the testing system 100 identifying a temperature and a SOC by the testing system 100 to optimally measure the impedance 160 associated with the s-parameters 150 and detect an internal state.

In one example, the testing system 100 identifies an optimal temperature, the SOC, and impedance for detecting the safety state and the residual value can include additional approaches. For instance, the testing system 100 measuring impedance 160 at target temperatures and SOCs parameters improves the effectiveness of detecting degradation and computing a safety state and a residual value using first derivative computations. These parametric targets can depend upon the internal architecture and chemistry profile of the used battery 202. The testing system 100 can adapt these parametric targets for reuse applications during impedance measurement involving the used battery 202 that further improve computational accuracy.

Moreover, in another approach, the testing system 100 selects a frequency band according to a cell layout and internal architecture (e.g., cylindrical cells, stacked sheets, etc.) of the used battery 202. As previously explained, the frequency band can be associated with the testing equipment measuring impedance from the used battery 202 when the ion response internally at a cell is dominant. Furthermore, the testing system 100 and the measurement module 130 can filter wear interference and measurement noise (e.g., sensor interference) to the used battery 202 using the frequency band. In this way, the testing system 100 can at a module level diagnose causes of impedance changes from measurements and real-parts of a first derivative for a cell accurately while reducing computational complexity.

The testing fixture 200 can include a second probe 208 (e.g., coaxial cables, electrical clips, clamps, etc.) using the measurement module 130 to measure the s-parameters 150 and the impedance 160. As explained below, the testing system 100 can observe reflection coefficients between ports of the used battery 202. In one approach, the testing system 100 computes differential values between the s-parameters 150 by factoring the reflection coefficients at elevated frequencies that indicate a connection quality between the second probe 208 and ports (e.g., terminals) of the used battery 202. For example, the second probe 208 forms a capacitive-resistance parallel circuit from the s-parameters 150 and reflection coefficients. This allows the testing system 100 to detect an abnormal connection between the second probe 208 and the used battery 202.

Moreover, the testing system 100 may adjust pressure and connection strength on the ports automatically until the differential values are within a tolerance range for a connection parameter. For example, the connection parameter includes one of a contact resistance and a voltage reflection. Here, adjustments can include moving the second probe 208 using an actuator 210 on a battery terminal. Movement can be in a 3D space and conducted to reduce resistance (e.g., contact resistance) and reflection coefficients until the differential value is minimized, satisfies a threshold, etc. In this way, the testing system 100 increases fidelity for impedance measurements, degradation detection, and a safety state.

In another example, the testing fixture 200 acquires sensor data for detecting defects besides degradation. Here, the testing fixture 200 can acquire an image associated with the used battery 202 using a camera. In one approach, the image captures a formation or deformation change (e.g., holes, color changes, etc.) of the used battery 202 casing for a module detectable by the testing system 100. As such, the testing fixture 200 using the testing system 100 can detect a deformation change of the casing using the image for both external and internal testing..

A protocol associated with FIG. 2 can include determining the battery characteristics 170. For example, the battery characteristics 170 are the safety state that indicates plating within a cell, a cell array, a module, etc., internal to the used battery 202 and a frequency band where the plating is prominent. In another approach, the safety state can involve extracting operating qualities over certain safety-related features of the used battery 202 (e.g., SOC, temperature, induction, etc.). As previously explained, plating can involve forming a metallic layer on an anode surface of the cell from improper intercalation of lithium ions into anode material and the lithium ions accumulating on the anode surface. The frequency band can be above a frequency having increased chemical breakdown and an ion response that is elevated when testing the used battery 202, thereby improving degradation detection.

The battery characteristics 170 can also include a parameter associated with the safety state indicating that one of a cell and the module internally within the used battery 202 has undetected plating on a surface of an anode associated with a threshold (e.g., a current output, a voltage output, etc.). Furthermore, in one embodiment, the battery characteristics 170 include a SOC that is one of a charge level and a discharge level associated with chemical degradation, a functionality state for the used battery 202, and the safety state and a weighting factor. For instance, the functionality state can be a residual value of the used battery 202 as a power source in a reuse application. As further explained below, the residual value or functionality state can be directly correlated with the safety state for the used battery 202.

In yet another embodiment, the testing system 100 and the measurement module 130 include instructions that cause the processor 110 to detect physical and chemical changes about the internal state of a battery (e.g., a lithium-ion battery) from s-parameter and impedance measurements. In one approach, detection involves having a frequency band for impedance measurements that exceeds a frequency (e.g., 100 Hz, 1 kHz, 1 MHz, etc.) where the ion response inside the battery is dominant. This allows the testing system 100 to accurately diagnose causes of impedance changes from impedance values and a first derivative for a frequency, such as variable frequencies *f₁* to *f₂*. A diagnosis can include one of a safety state, the existence of lithium metal deposition, lithium plating inside at least one battery cell, and a residual value. For example, the residual value is a state of function (SOF), a state of functionality, etc., associated with the used battery 202 for reuse applications. As such, the residual value exceeding a minimal parameter, threshold, etc., can indicate that one or more cells within the used battery 202 exhibit sparse plating or lack metallic plating, thereby increasing opportunities for reuse 212 rather than recycling 214 that creates waste. Otherwise, the residual value may indicate that the used battery 202 is unsuitable and unsafe for reuse opportunities. The testing system 100 may output a value indicating that the used battery 202 should be recycled.

In the testing fixture 200, the conveyor device 204 may route the used battery 202 for reuse 212 when the residual value exceeds a minimal parameter, threshold, etc., for reuse applications. In one approach, this includes the testing system 100 detecting a mechanical deformation and a cell shift within a module of the used battery 202 from inductive interference between an external object that is metallic and a contact tab within the module. For instance, the mechanical deformation is associated with a collision involving a vehicle.

In one example, the testing system 100 computes a functionality state for the used battery 202 using the safety state and a weighting factor and a health state. Here, the functionality state represents a residual value of the used battery 202 as a power source in a reuse application. Otherwise, the conveyor device 204 routes the used battery 202 for recycling 214 and disposal when the safety state indicates plating within a cell of a module internal to the used battery 202.

Moreover, the testing system 100 computes a functionality state from a SOF, a SOS, and a SOH. For example, SOF weights a SOS with a SOH and forms Equation (1): $SOF = α x SOH x SOS .$ Equation (1) The variable *α* can be a weighting factor that can depend upon one of a battery chemistry, a cellular structure, casing material, application environment, usage environment (e.g., commercial backup, an electric vehicle), etc. In this respect, the variable *α* improves reuse and resale determinations by incorporating and factoring additional context to SOF for the used battery 202. For instance, the testing system 100 computes a functionality state, SOF, etc., for the used battery 202 using the safety state and the weighting factor, and the SOH.

In Equation (1), the SOH can be reuse-dependent using classes and indicate one of a remaining capacity and a charging capacity of the used battery 202. For example, a class for vehicle reuse demands an elevated SOH (e.g., 90%) for the charging capacity while residential reuse can tolerate a lower SOH (e.g., 80%). Meanwhile, ultra-critical installations such as hospitals may demand a SOH above 95%. As such, the testing system 100 can reliably output one of a safety state that indicates degradation such as metallic plating and a residual value for the used battery 202. This allows downstream systems to automatically identify that the used battery 202 is viable for reuse, compute reuse values, and assign the used battery 202 to particular applications through routing with conveyor device 204. Otherwise, the downstream system generates a recycling plan from the output since the used battery 202 is one of defective, worn beyond repair, and exhibits limited market value.

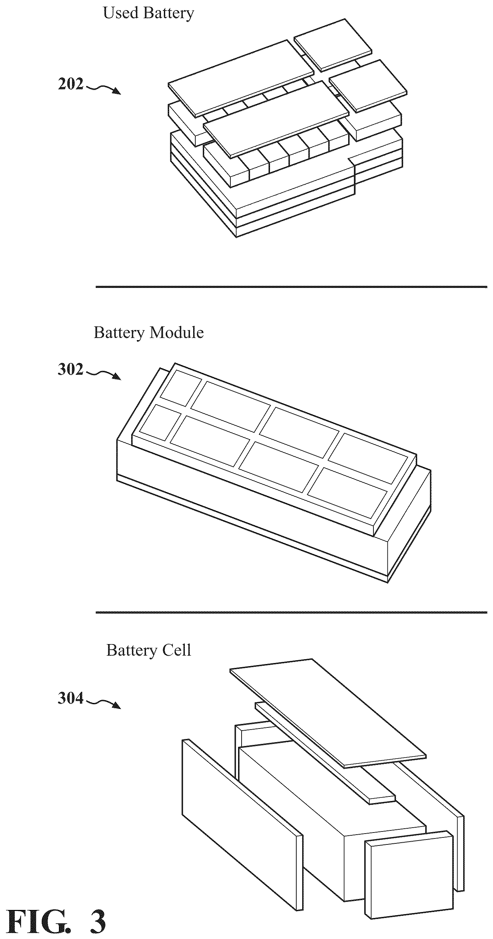

Turning to FIG. 3, an example of the used battery 202 having a battery module 302 and a battery cell 304 that are embedded and the testing system 100 analyzes for degradation is illustrated. In various implementations, the testing system 100 measures the impedance 160 at a module level for the used battery 202 and executes computations involving first derivatives of the impedance 160. As such, this allows removing interference sources having first derivative properties for the impedance 160 that are unchanged and negligible (e.g., zero). This can include mitigating inductive interference from iron by computing second derivatives from the impedance 160. Furthermore, estimating the safety state for the used battery 202 can include computing eddy interference using a linear relationship derived from the first derivatives. As explained below, this allows identifying plating within the used battery 202 from a difference between two values of a first derivative using the testing device without disassembling cells associated with the used battery 202.

The testing system 100, in one approach, outputs an indication of the plating and a residual value about the used battery 202. Here, the residual value indicates a degree of the used battery 202 being a power source in a reuse application. This approach also facilitates estimating a safety state and degradation (e.g., a chemical degradation, a physical degradation, etc.) for the battery cell 304 within the battery module 302 of the used battery 202 without invasive disassembly and expensive testing equipment. In this way, the approach by the testing system 100 reduces system complexity.

In the examples given herein, the testing system 100 can also identify plating of a terminal within the used battery 202 from a difference between two values of a first derivative. This also allows the testing system 100 to compute a safety state for the used battery 202 without impedance tracking from a timepoint and an initial state that the used battery 202 is manufactured. For instance, a third-party battery can lack a high-frequency sensor that measures the impedance 160 in the one of the battery module 302 and the battery cell 304. In this way, the testing system 100 can output a safety state and a residual value about the used battery 202 that indicates an available degree in a reuse application from various manufacturers.

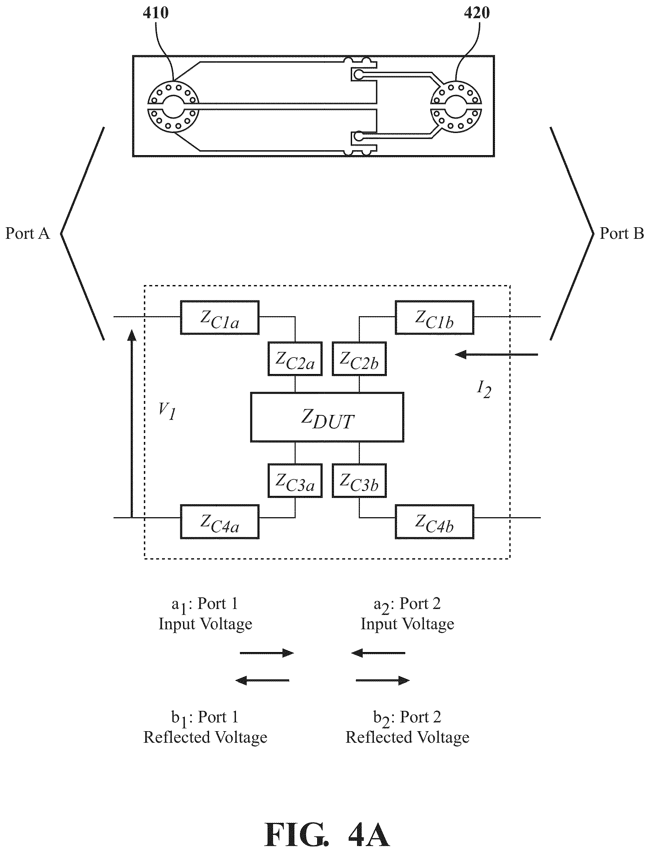

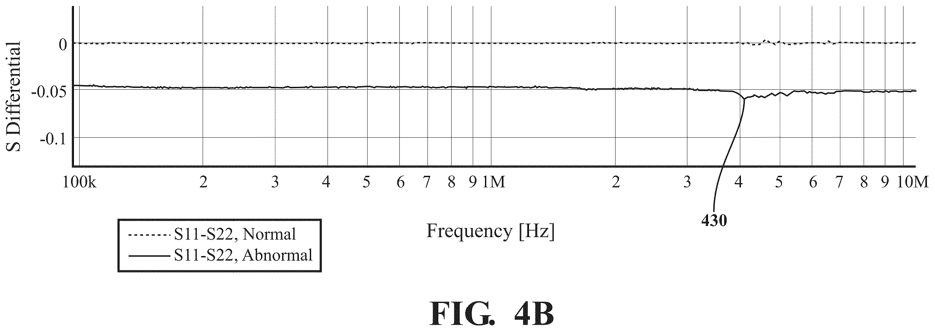

Concerning FIGS. 4A and 4B, embodiments of verifying port connections through analyzing the s-parameters 150 and differential values are illustrated. In FIG. 4A, the testing system 100 measures the s-parameters 150 using a negative port 410 and a positive port 420. Here, Port A can be associated with one of the first probe 206 and the second probe 208 side while Port B represents the used battery 202 side. The testing system 100 forms various circuits for measuring the s-parameters 150 that is unitless. For instance, *Z_{C1a}* and *Z_{C4a}* form a series circuit to determine the impedance 160 for the used battery 202 as the device under test (DUT). The DUT can also be one of the used battery 202, the battery module 302, and the battery cell 304.

Another approach is a 4-port measurement by the testing system 100. Here, the impedance of target *Z_{DUT}* can be measured by Equations (2)-(4). $\left[\begin{matrix}{V}_{1} \\ {V}_{2}\end{matrix}\right] = Z \left[\begin{matrix}{I}_{1} \\ {I}_{2}\end{matrix}\right] ,$ Equation (2) $\left[\begin{matrix}{V}_{1} \\ {V}_{2}\end{matrix}\right] = \left[\begin{matrix}{Z}_{11} & {Z}_{12} \\ {Z}_{21} & {Z}_{22}\end{matrix}\right] \left[\begin{matrix}{I}_{1} \\ {I}_{2}\end{matrix}\right] ,$ Equation (3) ${Z}_{21} = \frac{{V}_{1}}{{I}_{2}} = \left({Z}_{DUT}\right) .$ Equation (4) In Equations (2)-(4), the testing system 100 utilizes voltage *V,* current *I,* and impedance Z readings between various ports (e.g., port 1, port 2, etc.) to compute the impedance 160 associated with the used battery 202. The testing system 100 conducting measurements on a 2-port network can involve reading reflections and a path associated with waveform information. This can be modeled to measure the s-parameters 150 of DUT using Equation (5) and Equation (6): $\left[\begin{matrix}{b}_{1} \\ {b}_{2}\end{matrix}\right] = S \left[\begin{matrix}{a}_{1} \\ {a}_{2}\end{matrix}\right] ,$ Equation (5) $\left[\begin{matrix}{b}_{1} \\ {b}_{2}\end{matrix}\right] = \left[\begin{matrix}{S}_{11} & {S}_{12} \\ {S}_{21} & {S}_{22}\end{matrix}\right] \left[\begin{matrix}{a}_{1} \\ {a}_{2}\end{matrix}\right]$ Equation (6) The variables include *a₁* as port 1 input voltage, *a₂* as port 2 input voltage, *b₁* as port 1 reflected voltage, and *b₂* as port 2 reflected voltage.

In various implementations, FIG. 4 illustrates that the 2-port network is effective for measuring ***Z*** or ***S*** of the DUT with removing impedances *Z_{cxx}*. In particular, a matrix ***S*** can be converted to ***Z*** by using Equation (7) and Equation (8), $Z = {Z}_{0} \left(U+S\right) {\left(U-S\right)}^{- 1}$ Equation (7) ${Z}_{21} = {Z}_{12} = {Z}_{0} \frac{{S}_{12} + {S}_{21}}{\left(1-{S}_{11}\right) \left(1-{S}_{22}\right) - {S}_{12} {S}_{21}} ,$ Equation (8) where ***U*** is a unit matrix and *Zₒ* is a reference impedance (e.g., 50 Ω, 100 Ω, etc.). Here, computations involving Equation (7) and Equation (8) involve adjusting *S₁₁* and *S₂₂* so that the values are similar. As such, the testing system 100 can automatically control a contact interface with the used battery 202 until *S₁₁* and *S₂₂* have similar values.

FIG. 4B illustrates that a normal connection between *S₁₁-S₂₂* has one of a straight, uniform, flat, etc., waveform. In other words, the differential between *S₁₁* and *S₂₂* is constant (e.g., zero) and represent positive or negative values. Here, the testing system 100 conducts contact evaluation for one of an elevated frequency range (e.g., greater than 1 MHz), a wide bandwidth (BW), etc., that reduces difficulties associated with assessing equivalence. For instance, low frequencies exhibit minimal absolute values that preclude evaluating capacitive components from contact impedance. As such, the testing system 100 utilizes differential values between *S₁₁* and *S₂₂* in the high-frequency range along with derivative computations for accurately identifying a safety state associated with the used battery 202.

As previously explained, *S₁₁* and *S₂₂* exhibit similar values if the +/- terminals are finely connected. The abnormal connection 430 between *S₁₁* and *S₂₂* exhibits an offset (e.g., a bump, a value difference, etc.) at elevated frequencies. This indicates one of misalignment, an improper connection, etc., between the second probe 208 of the testing system 100 and battery ports. In one approach, the testing system 100 reduces the offset by automatically adjusting the connection level through moving the second probe 208 using the actuator 210. This allows the testing system 100 to adjust port pressure to fall within a tolerance range, thereby stabilizing the connection between the used battery 202 and the second probe 208 and generating measurement evaluations that are reproducible. The adjustment also ensures minimizing contact resistance, thereby improving estimates for a safety state. The used battery 202 is unusable and recycled if a component (e.g., module, cell, etc.) has an unacceptable safety state, such as due to metal plating and a cell malfunction.

Still referring to FIGS. 4A and 4B, the testing system 100 removes interference sources by computing first derivatives of real-parts from impedance 160 using the s-parameters 150 upon satisfying a connection parameter. As previously described, the connection parameter includes one of a contact resistance and a voltage reflection. Here, the testing system 100 may compute one or more of the following first derivatives from impedance measurements associated with the used battery 202: a first derivative of a real-part from an impedance value, a first derivative of an imaginary-part from the impedance value, a difference between real-parts from first derivatives of impedance values among two frequency points, a difference between imaginary-parts from first derivatives of impedance values among the two frequency points, the real-part of the impedance value, and the imaginary-part of the impedance value. For instance, two frequency points are the variable frequencies *f₁* to *f₂* within a frequency band exhibiting increased chemical breakdown and an ion response associated with the used battery 202. This allows the testing system 100 to reliably and non-invasively detect internal degradation and plating using first derivative computations at a module level. Furthermore, derivative computations can proceed upon filtering impedance measurements for noise by intelligently selecting the frequency band through accounting for battery architectures and profiles.

In another approach, the testing system 100 measures the impedance 160 at target temperatures and SOCs that improve the effectiveness of detecting degradation and a residual value using first derivative computations. These targets can depend upon the internal architecture and chemistry of the used battery 202. Furthermore, the first derivative of the real-parts from the impedance 160 exhibit properties that allow the testing system 100 to target metal deposition and degradation (e.g., a chemical degradation, a physical degradation, etc.) through mitigating interference sources. For the examples given, the interference sources can be associated with one of a cell, a module, a cell array, etc., for the used battery 202. Correspondingly, the testing system 100 can accurately compute a SOF for the used battery 202 during testing when reducing interference.

The testing system 100 can externally detect at a module level degradation for internal cells that avoids invasive and complex testing. Here, a first derivative nullifies, mitigates, eliminates, removes, etc., contact interference (e.g., iron contacts, copper contacts, etc.) for the used battery 202 during impedance measurements by the second probe 208. Contact interference may originate from internal cells within the battery module 302 experiencing a loosening, tightening, etc., for a coupling between terminals, contact tabs, etc. The difference between the real-parts from the first derivatives of the impedance values among the two frequency points can nullify, mitigate, eliminate, remove, etc., inductive interference (e.g., iron-based induction).

In another example, the interference sources are an inductive interference from iron and a contact interference associated with one of a cell, a module, a cell array, etc., within the used battery 202. Here, the testing system 100 can convert real-parts of the impedance 160 to a percentage value for minimizing inductive interference (e.g., eddy current) and emphasizing changes caused from metallic plating through observing linear relationships. This approach also reduces computations by the testing system 100 from leveraging monotonically increasing relationships.

In various implementations, the testing system 100 includes an analysis protocol that retrieves context parameters about the used battery 202. For instance, the testing system 100 factors the context parameters and the difference between real-parts from first derivatives of impedance values among the two frequency points when selecting a threshold for the safety state and the residual value. Here, the testing system 100 analyzing the residual value can diagnose other defects besides internal degradation, plating, etc. In one approach, the threshold is associated with a plating level involving a particular battery chemistry (e.g., lithium-ion), usage profile (e.g., harsh weather, rough terrain, aggressive driving, etc.), etc. This allows the testing system 100 to increase the reliability and accuracy of the safety state and residual value outputs through intelligently selecting the threshold.

The testing system 100, in yet another example, estimates one of a safety state, a SOF, and the physical degradation for the used battery 202 through computing eddy interference. For instance, the testing system 100 utilizes a linear relationship derived from first derivatives of real-parts associated with impedance measurements by the second probe 208. This allows the testing system 100 to diagnose the physical degradation as one of material wear and solid electrolyte interphase (SEI) growth. This also allows the testing system 100 to diagnose an eddy current from inductive interference while avoiding complex testing tasks.

In certain embodiments, the testing system 100 detects plating of a terminal within the used battery 202 from a difference between two values of a first derivative within the frequency band without disassembling cells. As previously explained, the testing system 100 can compute a safety state for the used battery 202 without impedance tracking from a timepoint that the used battery 202 is manufactured upon satisfaction of a cycling parameter. For instance, the cycling parameter represents a number of cycles and extreme operating temperatures experienced by the used battery 202. Thus, the testing system 100 can output a safety state about the used battery that indicates an available degree of the used battery 202 being a power source in a reuse application.

Regarding more details about interference sources, contact interference may originate from internal cells within the battery module 302 experiencing a loosening, tightening, etc., for a coupling between terminals. Coupling interference can originate from a metal material external to the used battery 202 impacting one of the battery module 302, the battery cell 304, etc., within the used battery 202. The testing system can leverage first derivatives of the real-parts from the impedance 160 changing between two or more frequency points as indicating an interference source and related degrees without testing tasks that are invasive.

The testing system 100 may avoid complex testing through the first derivative computations detecting the interference sources for internal cells externally at a module level using targeted testing. For instance, the testing system 100 measures impedance 160 at target temperatures and SOCs exhibiting increased chemical reactivity that improves the effectiveness of detecting degradation and a residual value using first derivative computations. A target SOC of 20% can represent a residential reuse application that is non-critical while 85% can represent critical applications. In another approach, these targets can depend upon internal architecture and chemistry of the used battery 202. The testing system 100 can adapt these targets for reuse applications involving the used battery 202, thereby further improving computational accuracy.

In many respects, the first derivative nullifies, mitigates, eliminates, removes, etc., contact interference for the used battery 202 during impedance measurements involving selected frequency bands. Contact interference may be from internal cells within the battery module 302 experiencing a loosening, tightening, etc., for a coupling between terminals that is readily measurable within a frequency band. In one approach, the testing system 100 has the negative port 410 and the positive port 420 between internal cells, modules, etc., as contact tabs. The testing system 100 can experience reduced reliability and accuracy from contact interference during impedance measurements. As such, the testing system 100 adjusts the second probe 208 using an actuator 210 on one of the negative port 410 and the positive port 420. For example, movement can be in a 3D space and conducted to reduce resistance (e.g., contact resistance) and reflection coefficients until the differential value is minimized, satisfies a threshold, etc. The testing system 100 can also compute the first derivative to remove contact interference for the used battery 202 during impedance measurements. In this way, the testing system 100 improves accuracy and reliability for detecting battery degradation and estimating a safety state.

As previously explained, the testing system 100 may convert real-parts of the impedance 160 to a percentage value for minimizing inductive interference from eddy currents. This conversion can also magnify changes caused from metallic plating through observing linear relationships. Furthermore, the testing system 100 and the measurement module 130 can naturally filter wear interference and measurement noise (e.g., sensor interference) to the used battery 202 by targeting certain frequency bands. In one approach, the frequency bands can be associated with the specific structure and production of the used battery 202. For instance, the testing system 100 executing impedance measurements are impacted by the used battery 202 having one of cylindrically rolled cells, stacked plates, etc., below a certain frequency. As such, the testing system 100 measuring above the certain frequency can remove the wear and aging interference through factoring battery structure.

The testing system 100 computing a difference between the real-parts from the first derivatives of impedance values among the two frequency points can also nullify, mitigate, eliminate, remove, etc., inductive interference (e.g., iron-based induction). Here, an external object that is metallic, magnetic, etc., causes inductive interference with the battery module 302, the battery cell 304, etc., during impedance measurements. For example, the battery cell 304 has aluminum, stainless steel, etc., material that inductively couples with the external object near the used battery 202. This coupling may occur even with polymers, plastic, etc., as the housing and shielding for a battery module. In this way, the testing system 100 removing inductive interference can improve computations for a safety state and a residual value including wear-related defects.

As previously described, the testing system 100 can detect mechanical deformation and a shift within the used battery 202 from the inductive interference between the external object and one of the negative port 410 and the positive port 420. This can include detecting a cell shift within the battery module 302 between cells. Here, the cells can be connected by one of the negative port 410 and the positive port 420. The mechanical deformation can be caused by a collision involving the vehicle, an accident, an external force, impact, modules shifting, geometric cell changes, etc. Similar to metallic plating, the testing system 100 identifies and detects the mechanical deformation and the cell shift while avoiding invasive techniques that can damage battery hardware.

In various implementations, the testing system 100 executes second derivative computations of the impedance 160 (e.g., real-parts of impedance). This enhances diagnosing internal plating at the module level while removing and mitigating additional interference sources than first derivative operations. Here, the second derivative can eliminate and zero out inductive interference from iron. This interference source has first-order characteristics that are constant allowing a second derivative computation of the impedance 160 to cancel the effect.

Moreover, the second derivative also simplifies removing eddy current from induction as an interference source by making the effect constant. For example, the testing system 100 can reliably differentiate between an eddy current and internal plating affecting impedance measurements by the measurement module 130 using second derivative computations along with first derivative computations. In this way, the testing system 100 can reduce effects from eddy currents when identifying internal degradation of the used battery 202.

The testing system 100 can also filter noise caused from derivative calculations. For example, the testing system 100 factors cell arrangement and targets a frequency band having optimal characteristics that enhance plating effects. Similar to other approaches, this example involves comparing values of second derivatives from impedance measurements against a threshold for identifying internal plating of the battery module 302, the battery cell 304, etc. Accordingly, the testing system 100 accurately detects degradation of cells within the used battery 202 through optimizing s-parameters and derivative computations non-invasively while decreasing testing complexity and component damage.

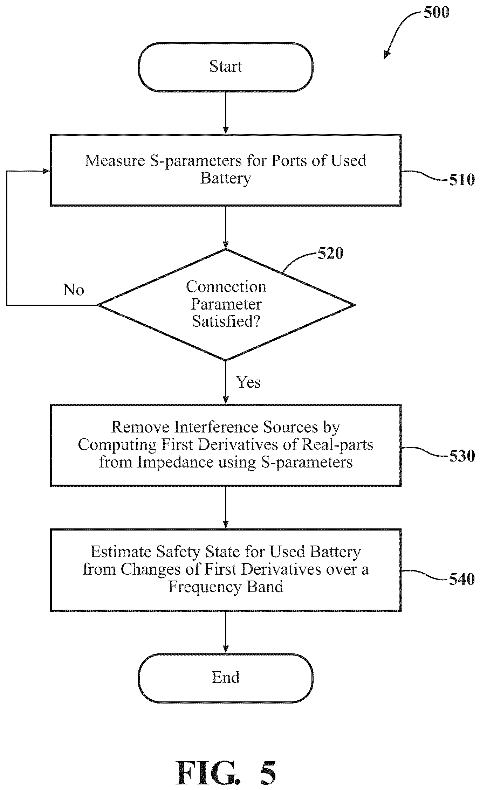

Now discussing FIG. 5, a flowchart of a method 500 that is associated with measuring the s-parameters 150 for ports of the used battery 202 and satisfying a connection parameter for estimating a safety state is illustrated. The method 500 will be discussed from the perspective of the testing system 100 of FIG. 1. While the method 500 is discussed in combination with the testing system 100, it should be appreciated that the method 500 is not limited to being implemented within the testing system 100 but is instead one example of a system that may implement the method 500.

At 510, the measurement module 130 measures the S-parameters 150 for ports of the used battery 202. The s-parameters 150 can be a unitless value about electrical characteristics and responses associated with the used battery 202. For example, the testing system 100 observes reflection coefficients between ports of the used battery 202. As such, the testing system 100 computes differential values between the s-parameters 150 by factoring the reflection coefficients at elevated frequencies that indicate a connection quality between testing probes and ports (e.g., terminals) of the used battery 202. The reflection coefficients can be associated with one of voltage, current, etc., observed between testing probes and ports (e.g., terminals) of the used battery 202. As explained above, this allows the testing system 100 to independently analyze contact impedance of a port using a capacitive-resistance parallel circuit from the s-parameters 150 and reflection coefficients, thereby accurately identifying contact quality for safety testing.

At 520, the testing system 100 compares the s-parameters 150 against a connection parameter. As previously explained, the connection parameter includes one of a contact resistance and a voltage reflection. Here, the testing system 100 may adjust pressure and connection strength on the ports automatically until differential values between the s-parameters 150 are within a tolerance range for the connection parameter. For instance, as previously explained, the testing system 100 utilizes differential values between the s-parameters 150 across a testing probe and a battery port in a high-frequency range that enhances one of connection resistance and interference. This includes additional measurements of the s-parameters 150 when the connection parameter is unsatisfied.

Moreover, adjustments can include moving a probe measuring the s-parameters 150 using an actuator on a battery terminal. Here, movement can be in a 3D space and conducted to reduce resistance (e.g., contact resistance) and reflection coefficients until the differential value is minimized, satisfies a threshold, etc. This allows the testing system 100 to adjust port pressure to fall within a tolerance range and stabilize a connection between the used battery 202 and the second probe 208. This enables reproducible measurement evaluations and ensures minimizing contact resistance, thereby improving estimates for a safety state.

At 530, the testing system 100 removes interference sources by computing first derivatives of real-parts from the impedance 160 using the s-parameters 150. Here, the interference sources can be associated with one of a cell, a module, a cell array, etc., for the used battery 202. In various implementations, the testing system 100 measures the impedance 160 at a module level for the used battery 202 and executes computations involving first derivatives of the impedance 160. This allows removing interference sources having first derivative properties for the impedance 160 that are unchanged and negligible (e.g., zero), such as contact interference. This can also include mitigating inductive interference from iron by computing a second derivative from the impedance 160 that may exhibit a constant first derivative.

Moreover, contact interference may be from internal cells within the battery module experiencing a loosening, tightening, etc., for a coupling between terminals that is readily measurable within a frequency band. In one approach, the testing system 100 has a negative port and a positive port between internal cells, modules, etc., as contact tabs. The testing system 100 can experience reduced reliability and accuracy from contact interference during impedance measurements. Furthermore, the interference sources include an inductive interference from iron and a contact interference associated with one of a cell, a module, a cell array, etc., within the used battery 202. In yet another interference source is measuring above a certain frequency for removing wear and aging interference through factoring battery structure.

At 540, the testing system 100 estimates a safety state for the used battery 202 from changes of first derivatives over a frequency band. For instance, the testing system 100 computes a difference between the real-parts from the first derivatives of impedance values among the two frequency points that nullify, mitigate, eliminate, remove, etc., contact interference, inductive interference (e.g., iron-based induction), eddy interference, and aging interference. Here, an external object that is metallic, magnetic, etc., can cause inductive interference with the battery cell, the battery module, etc., during impedance measurements. For example, the battery cell has aluminum, stainless steel, etc., material that inductively couples with the external object near the used battery 202. As such, mitigating this interference improves the accuracy of safety state computations by the testing system 100.

Moreover, the testing system 100 estimating the safety state for the used battery 202 can involve computing eddy interference using a linear relationship derived from the first derivatives. As previously explained, this allows identifying plating within the used battery 202 from a difference between two values of a first derivative using the testing system 100 without dissembling cells. In this way, the testing system 100 improves measurement quality and mitigates various interference sources that improves computations for the safety state through increasing fidelity for impedance measurements and degradation detection.

Detailed embodiments are disclosed herein. However, it is to be understood that the disclosed embodiments are intended as examples. Therefore, specific structural and functional details disclosed herein are not to be interpreted as limiting, but merely as a basis for the claims and as a representative basis for teaching one skilled in the art to variously employ the aspects herein in virtually any appropriately detailed structure. Furthermore, the terms and phrases used herein are not intended to be limiting but rather to provide an understandable description of possible implementations. Various embodiments are shown in FIGS. 1-5, but the embodiments are not limited to the illustrated structure or application.

The flowcharts and block diagrams in the figures illustrate the architecture, functionality, and operation of possible implementations of systems, methods, and computer program products according to various embodiments. In this regard, a block in the flowcharts or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved.

The systems, components, and/or processes described above can be realized in hardware or a combination of hardware and software and can be realized in a centralized fashion in one processing system or in a distributed fashion where different elements are spread across several interconnected processing systems. Any kind of processing system or another apparatus adapted for carrying out the methods described herein is suited. A typical combination of hardware and software can be a processing system with computer-usable program code that, when being loaded and executed, controls the processing system such that it carries out the methods described herein.

The systems, components, and/or processes also can be embedded in a computer-readable storage, such as a computer program product or other data programs storage device, readable by a machine, tangibly embodying a program of instructions executable by the machine to perform methods and processes described herein. These elements also can be embedded in an application product which comprises the features enabling the implementation of the methods described herein and, which when loaded in a processing system, is able to carry out these methods.

Furthermore, arrangements described herein may take the form of a computer program product embodied in one or more computer-readable media having computer-readable program code embodied, e.g., stored, thereon. Any combination of one or more computer-readable media may be utilized. The computer-readable medium may be a computer-readable signal medium or a computer-readable storage medium. The phrase "computer-readable storage medium" means a non-transitory storage medium. A computer-readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer-readable storage medium would include the following: a portable computer diskette, a hard disk drive (HDD), a solid-state drive (SSD), a ROM, an EPROM or flash memory, a portable compact disc read-only memory (CD-ROM), a digital versatile disc (DVD), an optical storage device, a magnetic storage device, or any suitable combination of the foregoing. In the context of this document, a computer-readable storage medium may be any tangible medium that can contain, or store a program for use by or in connection with an instruction execution system, apparatus, or device.

Generally, modules as used herein include routines, programs, objects, components, data structures, and so on that perform particular tasks or implement particular data types. In further aspects, a memory generally stores the noted modules. The memory associated with a module may be a buffer or cache embedded within a processor, a RAM, a ROM, a flash memory, or another suitable electronic storage medium. In still further aspects, a module as envisioned by the present disclosure is implemented as an ASIC, a hardware component of a system on a chip (SoC), as a programmable logic array (PLA), or as another suitable hardware component that is embedded with a defined configuration set (e.g., instructions) for performing the disclosed functions.

Program code embodied on a computer-readable medium may be transmitted using any appropriate medium, including but not limited to wireless, wireline, optical fiber, cable, radio frequency (RF), etc., or any suitable combination of the foregoing. Computer program code for carrying out operations for aspects of the present arrangements may be written in any combination of one or more programming languages, including an object-oriented programming language such as Java^{™}, Smalltalk^{™}, C++, or the like and conventional procedural programming languages, such as the "C" programming language or similar programming languages. The program code may execute entirely on the user's computer, partly on the user's computer, as a stand-alone software package, partly on the user's computer and partly on a remote computer, or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

The terms "a" and "an," as used herein, are defined as one or more than one. The term "plurality," as used herein, is defined as two or more than two. The term "another," as used herein, is defined as at least a second or more. The terms "including" and/or "having," as used herein, are defined as comprising (i.e., open language). The phrase "at least one of ... and ...." as used herein refers to and encompasses any and all combinations of one or more of the associated listed items. As an example, the phrase "at least one of A, B, and C" includes A, B, C, or any combination thereof (e.g., AB, AC, BC, or ABC).

Aspects herein can be embodied in other forms without departing from the spirit or essential attributes thereof. Accordingly, reference should be made to the following claims, rather than to the foregoing specification, as indicating the scope hereof.

## Claims

1. A testing system comprising:
a memory storing instructions that, when executed by a processor, cause the processor to:
measure s-parameters for ports of a used battery at elevated frequencies using a testing device;
upon satisfaction of a connection parameter associated with the ports, remove interference sources by computing first derivatives of real-parts from impedance using the s-parameters; and
estimate a safety state for the used battery from changes of the first derivatives over a frequency band.

2. The testing system of claim 1, wherein the instructions to measure the s-parameters for the ports further include instructions to:
identify reflection coefficients between the ports; and
compute differential values between the s-parameters by factoring the reflection coefficients at the elevated frequencies.

3. The testing system of claim 2, wherein the instructions to satisfy the connection parameter further include instructions to:
adjust pressure on the ports by the testing device automatically until the differential values are within a tolerance range, wherein the connection parameter includes one of a contact resistance and a voltage reflection.

4. The testing system of claim 2, wherein the instructions to estimate the safety state for the used battery further include instructions to:
compute eddy interference using a linear relationship derived from the first derivatives;
identify plating within the used battery from a difference between two values of another first derivative using the testing device without disassembling cells associated with the used battery; and
output an indication of the plating and a residual value about the used battery, the residual value indicates a degree of the used battery being a power source in a reuse application.

5. The testing system of claim 2, wherein the instructions to remove the interference sources further include instructions to:
mitigate inductive interference from iron by computing second derivatives from the impedance.

6. The testing system of claim 1 further including instructions to:
acquire an image of a casing associated with the used battery by the testing device using a camera; and
detect a deformation change of the casing by the testing device using the image.

7. The testing system of claim 1 further including instructions to:
detect a mechanical deformation and a cell shift within a module of the used battery from inductive interference between an external object that is metallic and a contact tab within the module, wherein the mechanical deformation is associated with a collision involving a vehicle.

8. The testing system of claim 1 further including instructions to:
compute a functionality state for the used battery using the safety state and a weighting factor and a health state, and the functionality state is a residual value of the used battery as a power source in a reuse application; and
the safety state indicates plating within a cell of a module internal to the used battery.

9. A non-transitory computer-readable medium comprising:
instructions that when executed by a processor cause the processor to:
measure s-parameters for ports of a used battery at elevated frequencies using a testing device;
upon satisfaction of a connection parameter associated with the ports, remove interference sources by computing first derivatives of real-parts from impedance using the s-parameters; and
estimate a safety state for the used battery from changes of the first derivatives over a frequency band.

10. The non-transitory computer-readable medium of claim 9, wherein the instructions to measure the s-parameters for the ports further include instructions to:
identify reflection coefficients between the ports; and
compute differential values between the s-parameters by factoring the reflection coefficients at the elevated frequencies.

11. The non-transitory computer-readable medium of claim 10, wherein the instructions to satisfy the connection parameter further include instructions to:
adjust pressure on the ports by the testing device automatically until the differential values are within a tolerance range, wherein the connection parameter includes one of a contact resistance and a voltage reflection.

12. The non-transitory computer-readable medium of claim 10, wherein the instructions to estimate the safety state for the used battery further include instructions to:
compute eddy interference using a linear relationship derived from the first derivatives;
identify plating within the used battery from a difference between two values of another first derivative using the testing device without disassembling cells associated with the used battery; and
output an indication of the plating and a residual value about the used battery, the residual value indicates a degree of the used battery being a power source in a reuse application.

13. A method comprising:
measuring s-parameters for ports of a used battery at elevated frequencies using a testing device;
upon satisfying a connection parameter associated with the ports, removing interference sources by computing first derivatives of real-parts from impedance using the s-parameters; and
estimating a safety state for the used battery from changes of the first derivatives over a frequency band.

14. The method of claim 13, wherein measuring the s-parameters for the ports further includes:
identifying reflection coefficients between the ports; and
computing differential values between the s-parameters by factoring the reflection coefficients at the elevated frequencies.

15. The method of claim 14, wherein satisfying the connection parameter further includes:
adjusting pressure on the ports by the testing device automatically until the differential values are within a tolerance range, wherein the connection parameter includes one of a contact resistance and a voltage reflection.

16. The method of claim 14, wherein estimating the safety state for the used battery further includes:
computing eddy interference using a linear relationship derived from the first derivatives;
identifying plating within the used battery from a difference between two values of another first derivative using the testing device without disassembling cells associated with the used battery; and
outputting an indication of the plating and a residual value about the used battery, the residual value indicates a degree of the used battery being a power source in a reuse application.

17. The method of claim 14, wherein removing the interference sources further includes:
mitigating inductive interference from iron by computing second derivatives from the impedance.

18. The method of claim 13 further comprising:
acquiring an image of a casing associated with the used battery by the testing device using a camera; and
detecting a deformation change of the casing by the testing device using the image.

19. The method of claim 13 further comprising:
detecting a mechanical deformation and a cell shift within a module of the used battery from inductive interference between an external object that is metallic and a contact tab within the module, wherein the mechanical deformation is associated with a collision involving a vehicle.

20. The method of claim 13 further comprising:
computing a functionality state for the used battery using the safety state and a weighting factor and a health state, and the functionality state is a residual value of the used battery as a power source in a reuse application; and
the safety state indicates plating within a cell of a module internal to the used battery.
